Europäisches Patentamt

European Patent Office

Office européen des brevets

(19)

(11) Numéro de publication : **0 282 384 B1**

(12) # FASCICULE DE BREVET EUROPEEN

(45) Date de publication du fascicule du brevet :
01.07.92 Bulletin 92/27

(51) Int. Cl.⁵ : **G06F 11/20**

(21) Numéro de dépôt : **88400388.0**

(22) Date de dépôt : **19.02.88**

(54) **Procédé d'adressage d'éléments redondants d'une mémoire intégrée et dispositif permettant de mettre en oeuvre le procédé.**

(30) Priorité : **03.03.87 FR 8702835**

(43) Date de publication de la demande :
**14.09.88 Bulletin 88/37**

(45) Mention de la délivrance du brevet :
**01.07.92 Bulletin 92/27**

(84) Etats contractants désignés :
**DE FR GB IT NL**

(56) Documents cités :
**WO-A-80/01732
PATENT ABSTRACTS OF JAPAN, vol. 8, no. 151 (P-286)[1588], 13 juillet 1984; & JP-A-59 48 898 (HITACHI SEISAKUSHO K.K.)21-03-1984
PROCEEDINGS OF THE IEEE, vol. 74, no. 5, mai 1986, pages 684-698, IEEE, New York, US; W.R. MOORE: "A review of fault-toleranttechniques for the enhancement of integrated circuit yield"**

(73) Titulaire : **SGS-THOMSON MICROELECTRONICS S.A.
7, Avenue Galliéni
F-94250 Gentilly (FR)**

(72) Inventeur : **Gaultier, Jean-Marie Bernard
4 bis, rue de Puyloubier
F-13790 Rousset sur Arc (FR)**
Inventeur : **Devin, Jean
Résidence le Ponant Allée des Cigales
F-13100 Aix en Provence (FR)**

(74) Mandataire : **Ballot, Paul Denis Jacques et al
Cabinet Ballot-Schmit, 7, rue le Sueur
F-75116 Paris (FR)**

EP 0 282 384 B1

**Description**

La présente invention concerne un procédé d'adressage pour une mémoire intégrée et un dispositif permettant de mettre en oeuvre le procédé. Elle concerne plus particulièrement un procédé d'adressage d'éléments redondants de la mémoire.

Une mémoire intégrée comporte classiquement des éléments mémoires lignes adressables par des adresses lignes et des éléments mémoires colonnes adressables par des adresses colonnes. La mémoire comporte également des éléments mémoires de redondance qui sont destinés à remplacer des éléments de la mémoire défectueux. Ces éléments redondants sont constitués d'éléments mémoires lignes et colonnes, les lignes étant adressables également par des adresses ligne et les colonnes par des adresses colonnes.

Lorsqu'un élément dans la mémoire s'avère être défectueux à la suite du test de cette mémoire, l'adresse de cet élément est mémorisée par une batterie de fusibles dans laquelle on claque certains fusibles pour que l'état de chaque fusible traduise l'adresse de l'élément défectueux decelé.

Il est tout à fait naturel et usuel d'utiliser une batterie de fusibles pour chaque élément défectueux. Il est tout aussi naturel et usuel d'utiliser des batteries distinctes pour des éléments lignes et pour des éléments colonnes. Les tendances actuelles conduisent à prévoir de plus en plus d'éléments redondants, si bien que le nombre de batterie de fusibles augmente. Cette augmentation contribue d'une part à augmenter l'encombrement et d'autre part à augmenter les risques de défaut.

L'article Proceedings IEEE vol 74 n°5 pages 684-698 de W.R. Moore, mai 1986, décrit ce type de mémoire redondante.

L'objet de l'invention consiste à réduire l'encombrement des batteries d'aiguillage vers les éléments de redondance et cela en ne prévoyant qu'une seule batterie pour un couple ligne- colonne de la mémoire et en fixant à la fin du test de chaque ligne et colonne, par claquage d'un fusible, la nature de l'aiguillage. Le claquage ou non d'un fusible permet de savoir par conséquent s'il s'agit d'un élément défectueux ligne ou d'un élément défectueux colonne, ce qui permet d'orienter l'aiguillage vers un élément redondant ligne ou vers un élément redondant colonne. L'objet de l'invention est un procédé tel que défini dans la revendication 1.

On décrira ci-après un procédé d'adressage d'une mémoire intégrée qui comporte un réseau d'éléments mémoires lignes et des éléments mémoires colonnes adressables respectivement pour des adresses ligne et des adresses colonnes, au moins une batterie de fusibles pour mémoriser l'adresse d'un élément défectueux de la mémoire ; caractérisé en ce qu'il consiste :

– pour une batterie, à associer cette batterie à un couple d'adresse ligne et colonne ;
– à mémoriser par claquage de certains fusibles dans la batterie, après le test d'un élément mémoire, l'adresse soit d'un élément colonne dans le cas où l'élément défectueux est un élément colonne, soit d'un élément ligne dans le cas où l'élément défectueux est un élément ligne ;
– et à ne valider que les adresses lignes lorsque l'adresse mémorisée est celle d'un élément ligne ou que les adresses colonnes lorsque l'adresse mémorisée est celle d'un élément colonne pour adresser soit un élément redondant ligne, soit un élément redondant colonne.

L'invention sera mieux comprise à l'aide de la description détaillée faite à titre d'exemple non limitatif et illustrée par les dessins qui représentent :
– figure 1, un schéma de réalisation du dispositif de mise en oeuvre du procédé d'adressage selon l'invention,
– figure 2, un schéma détaillé d'un exemple de réalisation d'un élément de mémorisation selon la figure 1.

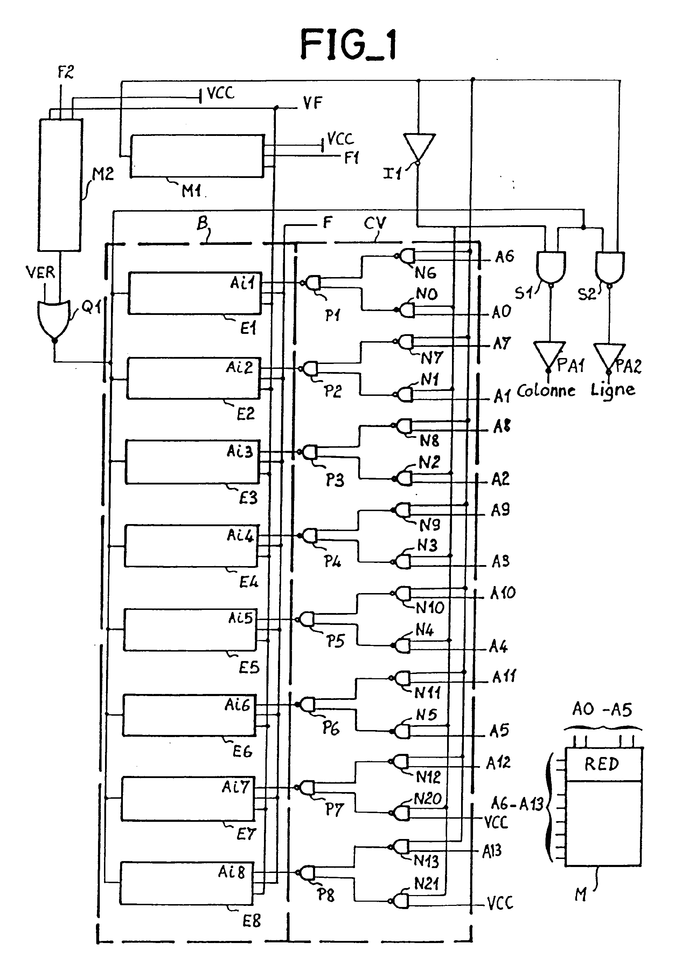

On a représenté sur la figure 1 un schéma général du dispositif permettant de mettre en oeuvre le procédé selon l'invention. La mémoire M est tout à fait classique c'est pourquoi elle a été représentée très schématiquement. Elle comporte bien entendu des éléments redondants RED et des circuits d'adressages lignes-colonnes non représentés mais classiques. Seuls les éléments B, CV, M1, M2, S1, S2 permettant l'aiguillage vers les éléments redondants sont décrits de manière détaillée et représentés.

La batterie de fusibles B qui est représentée permet selon le procédé de l'invention d'aiguiller une adresse ligne ou une adresse colonne, ce choix étant fait uniquement au moment du test de la mémoire M après détection d'un élément défectueux, selon qu'il s'agit d'un élément ligne ou d'un élément colonne. Ceci permet, contrairement à l'art antérieur de n'utiliser qu'une batterie pour un couple ligne-colonne, le choix étant fait après le test de la mémoire et non par avance.

Lorsqu'au cours du test de la mémoire un élément défectueux est détecté, le testeur qui n'a pas été représenté sur cette figure et qui est classique en soi, commande la mémorisation de la nature de l'élément par claquage ou non d'un fusible dans un élément de mémorisation M1 prévu à cet effet. Pour cela, une commande de claquage F1 est ou non appliquée avec une tension de claquage appropriée VF. Le fusible de l'élément de mémorisation est claqué ou n'est pas claqué selon que l'élément défectueux détecté est un élément ligne ou un élément colonne.

Le testeur va commander également le claquage d'un fusible d'un élément de mémorisation M2 qui sert à indiquer que l'on s'oriente (ou non en fonction de son état) vers un élément de redondance. La sortie de l'élément de mémorisation M1 permet de valider les entrées d'adresses lignes ou les entrées d'adresses colonnes du circuit de validation CV et ainsi de mémoriser dans la batterie les bits d'adressage validés. L'état de chaque fusible de la batterie correspond à un bit d'adressage d'une adresse d'un élément ligne ou colonne. La batterie comporte pour cela autant d'élément de mémorisation qu'il y a de bit d'adresse pour coder une ligne si l'on suppose, que le nombre de ligne est supérieur au nombre de colonne, ce qui est le cas en général. Dans le cas où le nombre de colonne est supérieur au nombre de lignes, le nombre d'élément de mémorisation est alors égal au nombre de bit d'adressage des colonnes.

Lorsque l'adresse d'une ligne ou d'une colonne d'un élément défectueux est mémorisée par la batterie, la batterie va permettre, avec les éléments de mémorisation M1 de sélection ligne ou colonne et l'élément de mémorisation de sélection d'élément redondant M2, l'aiguillage vers un élément redondant ligne ou un élément redondant colonne. Pour cela les sorties de chaque élément de la batterie et la sortie de l'élément de sélection (via une porte Non-Ou exclusif qui n'est pas obligatoire) sont réunies pour être appliquées à une entrée de deux portes, Non-ET référencées S1 et S2. Une deuxième entrée de la porte S1 reçoit le signal de sortie de l'élément de sélection M1 ligne ou colonne via un inverseur I1, tandis que la deuxième entrée de la porte S2 reçoit ce signal de sortie directement. La porte S1 permet par exemple d'adresser l'élément de redondance colonne désiré et la porte S2 permet d'adresser l'élément de redondance ligne désiré. La sortie de chacune des deux portes S1 et S2 est appliquée à l'entrée respective d'une porte inverseuse PA1, PA2 pour être adaptée avec la logique du circuit.

Le circuit de validation CV comporte pour chaque élément de mémorisation un couple de portes Non-ET. Une porte de chaque couple est destinée à recevoir à l'une de ses entrées un bit d'adresse ligne et à l'autre entrée un bit de validation ligne. L'autre porte reçoit à l'une de ses entrées un bit d'adresse colonne et à l'autre entrée un bit de validation colonne. Les entrées des bits d'adresse ligne sont numérotées A6-A13 et les entrées des bits d'adresse colonne sont numérotées A0-A5. La porte N6 et la porte NO forment un couple de validation des adresses A6, AO. La porte N6 reçoit le bit d'adresse A6 et le bit de sortie de l'élément de mémorisation M1. La porte NO reçoit le bit d'adresse AO et le bit de sortie de ce même élément M1 après inversion dans la porte inverseuse I1.

La porte N20 qui forme un couple de validation avec la porte N12, ne correspond plus dans ce cas particulier de réalisation à une entrée d'adresse colonne puisque le nombre d'adresse colonne est de cinq et que l'adresse A5 est appliquée à la porte N5. Cette porte N20 reçoit donc sur une de ses entrées un niveau de tension VCC. De même la porte N21 qui forme un couple de validation avec la porte N13, ne correspond plus à une entrée d'adresse colonne pour les mêmes raisons que précédemment.

Les sorties des deux portes d'un couple donné sont reliées respectivement à une entrée d'une porte Non-ET. Ainsi le couple N6, N10 est relié à la porte P1 et N13, N21 à P8. La sortie de chaque porte P1-P8 est reliée respectivement à l'entrée d'adresse d'un élément de mémorisation E1-E8, soit P1 à $A_i1$, P2 à $A_i2$... P8 à $A_i8$.

Une porte Non-Ou exclusif Q1 est prévue pour recevoir le signal de sortie de l'élément de sélection d'élément redondant M2 afin de permettre un test des éléments de redondance avant d'affecter définitivement un élément de redondance à la batterie. La porte Q1 reçoit pour cela par le testeur, à l'une de ses entrées un signal de vérification VER qui permet par conséquent de forcer la lecture de l'état de l'élément ligne ou colonne testé. Après vérification, si l'élément redondant est fonctionnel, le fusible de l'élément M2 est claqué par application d'une tension de claquage VF et d'une commande de claquage F2. C'est l'état de sortie de cet élément M2 et non plus le signal VER qui va permettre l'aiguillage vers l'élément redondant désiré avec également l'état de sortie de l'élément M1.

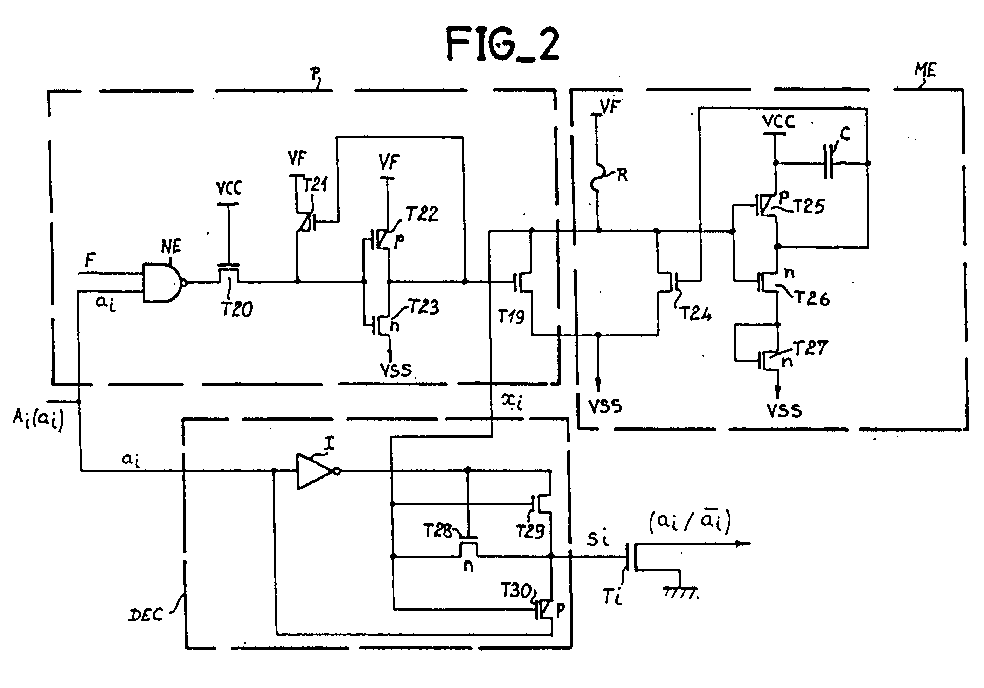

Sur la figure 2 on a représenté un exemple détaillé de réalisation d'un élément Ei de mémorisation d'adresse donné à titre indicatif et nullement limitatif.

L'élément Ei de mémorisation d'adresse comprend un circuit de programmation P qui reçoit le signal $a_i$ correspondant à un bit d'adresse Ai, la tension de commande de claquage F du fusible. Bien entendu les adresses Ai sont les adresses validées par le circuit CV. Le circuit P comporte une porte Non-Et, NE, et les transistors T19 à T23 et délivre un signal qui va provoquer un claquage (ou non) du fusible R par conduction (ou non) du transistor T19 à Vss.

L'élément de mémorisation Ei comprend également un circuit de mémorisation ME proprement dit qui reçoit la tension de claquage VF pour claquer le fusible R sur commande du circuit P. Ce circuit ME comporte le fusible R, des transistors T24 à T27, et un condensateur C et délivre pendant la lecture de l'état du fusible, un état $x_i$ traduisant l'état du fusible.

L'élément de mémorisation Ei comporte également un décodeur DEC qui reçoit également le signal $a_i$ correspondant à un bit d'adresse Ai et le signal $x_i$ correspondant à l'état du fusible R. Ce circuit DEC permet de délivrer le signal de sortie Si dont l'état est soit $a_i$ si l'état du fusible correspond bien à cet état, soit $\overline{a_i}$ ($a_i$ inversé) si l'état du fusible ne correspond pas à cet état. Le circuit DEC comporte un inverseur I, et les transistors T28 à T30. La sortie de ce circuit DEC est reliée à la grille d'un transistor $T_i$ dont une électrode est reliée à la masse et dont l'autre électrode forme la sortie de cet élément de mémorisation Ei. Cette sortie est reliée à toutes les autres sorties des circuits décodeurs DEC des autres éléments de mémorisation de la batterie B pour ne former qu'une seule sortie.

La réalisation des éléments de sélection M1 ou M2 est identique. Seuls les signaux d'entrée sont différents puisque on applique une tension VCC à l'entrée d'adresse de la porte NE, et un signal de commande de claquage différent pour les deux circuits respectivement F1, F2. Le circuit M1 reçoit donc un signal F1 sur une des entrées de la porte NE et le circuit M2 reçoit un signal F2 sur une des entrées de cette porte NE l'état de ces signaux permettant ou non de claquer le fusible R. La tension de claquage VF est formée de préférence par une même source pour tous les éléments M1, M2, E1-E8.

Pour claquer les fusibles dans une batterie, c'est-à-dire pour mémoriser une information, on applique un niveau bas sur toutes les entrées d'adresse de cette batterie puis on augmente la tension jusqu'à obtenir la tension de claquage VF, de 12 à 13 V généralement, puis on applique la tension de commande F, de 0 à 5 V généralement et on adresse successivement chaque élément.

Les entrées Ai1-Ai8 sont destinées à recevoir les signaux correspondant aux bits d'adresse en provenance du circuit de validation CV.

Les fusibles de sélection des élément M1 et M2 reçoivent au moment du claquage (à la place d'un bit d'adresse) une tension VCC de 5 V par exemple.

Lorsque l'on procède par la suite à une écriture puis à des lectures dans la mémoire, la sortie des éléments de mémorisation constituée par les sorties de chacun de ces éléments E1-E8 est à 0 (ou à 1) si l'adresse présentée à l'entrée de la batterie a été mémorisée par cette batterie et l'aiguillage se fait vers un élément de redondance ligne ou colonne selon que cette adresse est une adresse ligne ou une adresse colonne.

Cet exemple particulier de circuit a été réalisé en technologie CMOS, les transistors T20, T23, T19, T24, T27, T28, T29 étant des transistors MOS à canal N et les transistors T21, T22, T25, T30, étant des transistors à canal P.

## Revendications

1. Procédé d'adressage pour une mémoire intégrée qui comporte des éléments mémoire organisés en éléments lignes et éléments colonnes adressables respectivement par des adresses lignes et des adresses colonnes, des éléments redondants en ligne et des éléments redondants en colonne, au moins une batterie de fusibles pour mémoriser une adresse d'éléments défectueux à remplacer par un élément de redondance, caractérisé en ce qu'il consiste :

    – à associer la batterie indifféremment à une adresse en ligne ou une adresse en colonne, le choix entre adresse ligne et adresse colonne n'étant fait qu'au moment du test de la mémoire selon que l'élément défectueux à remplacer par un élément redondant est un élément ligne ou un élément colonne,

    – à mémoriser alors dans la batterie l'adresse ligne ou l'adresse colonne de l'élément défectueux,

    – à valider l'utilisation de la batterie soit comme mémoire d'adresse d'un élément de redondance ligne soit comme mémoire d'adresse d'un élément de redondance colonne pour l'utilisation ultérieure de la mémoire, et à relier à la batterie un élément de redondance correspondant ligne ou colonne,

    – à adresser l'élément de redondance ainsi relié chaque fois que l'adresse ligne ou colonne appliquée à la mémoire correspond à l'adresse ligne ou colonne mémorisée par la batterie.

2. Dispositif d'adressage d'éléments redondants d'une mémoire intégrée qui comporte un réseau d'éléments mémoires organisés en éléments ligne et éléments colonne adressables respectivement par des adresses lignes et des adresses colonnes, au moins un élément redondant en ligne et un élément redondant en colonne, au moins une batterie (B) de fusibles constituée d'éléments de mémorisation (E1-E8) pour mémoriser l'adresse d'un élément défectueux de la mémoire, et un élément de mémorisation (M2) de la sélection d'un élément de redondance, caractérisé en ce qu'il comporte :

    – un élément de mémorisation (M1) du choix ligne ou colonne, activé en fonction du fait que l'élément défectueux est un élément ligne ou un élément colonne,

    – un circuit de validation (CV, S1, S2) commandé par l'élément de mémorisation (M1) du choix ligne ou colonne, pour d'une part définir si une adresse stockée dans la batterie est une adresse de ligne ou une adresse de colonne, et d'autre part relier à la batterie un élément de redondance correspondant ligne ou colonne.

    – des moyens pour adresser l'élément de redondance ainsi relié chaque fois que l'adresse ligne ou colonne appliquée à la mémoire correspond à l'adresse ligne ou colonne mémorisée par la batterie.

3. Dispositif selon la revendication 2, caractérisé en ce que le circuit de validation (CV) comporte en correspondance avec chaque élément de mémorisation (Ei) un couple de portes logiques (N6, NO) dont une (N6) reçoit à l'une de ses entrées un bit d'adresse d'une adresse ligne (A6), et à une autre entrée un bit traduisant l'état de l'élément (M1) de sélection ligne ou colonne, l'autre porte (NO) recevant à l'une de ses entrées un bit d'adresse un bit d'adresse colonne, et à une autre entrée un bit traduisant l'état inverse de l'élément (M1) de sélection ligne ou colonne ;

    – et en ce que une porte logique (P1) à l'une de ses entrées reliée à la sortie d'une porte du couple (NO, N6), et une autre entrée reliée à la sortie de l'autre porte du couple (NO, N6), sa sortie étant reliée à l'entrée d'adressage (Ai1) d'un élément de mémorisation de la batterie B.

4. Dispositif selon la revendication 2 ou 3, caractérisé en ce que les éléments de mémorisation de sélection d'élément redondant (M2) et de sélection de ligne ou de colonne (M1) ont une commande de claquage (F1), (F2) distincte et distincte de celle des fusibles de la batterie.

## Claims

1. A method for addressing an integrated memory which comprises memory elements arranged in line elements and column elements addressable respectively by line addresses and column addresses, redundant line elements and redundant column elements, and at least one set of fuses for memorizing the address of defective elements to be replaced by a redundancy element, characterized in that it consists of:

    – connecting the set selectively to an address by line or an address by column, the choice between line address and column address not being made until the time of testing the memory depending on whether the defective element to be replaced is a line element or a column element,

    – then memorizing in the set the line address or the column address of the defective element,

    – validating the use of the set either as a memory for the address of a line redundancy element or as a memory for the address of a column redundancy element for the subsequent use of the memory, and connecting to the set a corresponding line or column redundancy element,

    – addressing the redundancy element thus connected each time the line or column address applied to the memory corresponds to the line or column address memorized by the set.

2. An arrangement for addressing redundant elements of an integrated memory which comprises a network of memory elements arranged in line elements and column elements addressable respectively by line addresses and column addresses, at least one redundant line element and one redundant column element, at least one set (B) of fuses consisting of storage elements (E1-E8) for memorizing the address of a defective element in the memory, and an element (M2) for memorizing the selection of a redundancy element, characterized in that it comprises:

    – an element (M1) for memorizing the choice of line or column, which is activated according to whether the defective element is a line element or a column element,

    – a validation circuit (CV, S1, S2) controlled by the element (M1) for memorizing the choice of line or column in order, on the one hand, to determine if an address stored in the set is a line address or a column address and, on the other hand, to connect to the set a corresponding line or column redundancy element,

    – means for addressing the redundancy element thus connected each time the line or column address applied to the memory corresponds to the line or column address memorized by the set.

3. An arrangement as claimed in claim 2, characterized in that the validation circuit (CV) comprises a pair of logic gates (N6, N0) corresponding with each memorizing element (E1), one (N6) of which receives on one of its inputs an address bit of a line address (A6) and on its other input a bit indicating the state of the line or column selection element (M1), the other gate (N0) receiving on one of its inputs a column address bit and on its other input a bit indicating the inverse state of the line or column selection element (M1),

    – and in that one logic gate (P1) has one of its inputs connected to the output of one gate of the pair (N0, N6) and another input connected to the output of the other gate of the pair (N0, N6), its output being connected to the address input (Ai1) of a storage element in the set B.

4. An arrangement as claimed in claim 2 or claim 3, characterized in that the elements for memorizing the selection of the redundant element (M2) and the selection of the line or column (M1) have separate breakdown commands (F1) and (F2), distinct from that of the fuses in the set.

## Patentansprüche

1. Verfahren zur Adressierung eines integrierten Speichers, umfassend Speicherelemente, die in Elementenzeilen und Elementenspalten organisiert sind und durch Zeilenadressen bzw. Spaltenadressen adressierbar sind, redundante Elemente als Zeile und redundante Elemente als Spalte, zumindest eine Anordnung von Sicherungen zum Speichern einer Adresse eines defekten Elements, das durch ein redundantes Element ersetzt werden soll, gekennzeichnet durch

    – Verbinden der Anordnung in nicht festgelegter Weise mit einer Zeilenadresse oder einer Spaltenadresse, wobei die Wahl zwischen Zeilenadresse und Spaltenadresse nur im Moment des Testes des Speichers erfolgt und zwar je nachdem, ob das defekte und durch ein redundantes Element auszuwechselnde Element ein Zeilenelement oder ein Spaltenelement ist,

    – anschließendes Speichern in der Anordnung der Zeilenadres se oder der Spaltenadresse des defekten Elementes,

– Bestätigen der Verwendung der Anordnung entweder als Adressenspeicher eines redundanten Zeilenelementes oder als Adressenspeicher eines redundanten Spaltenelementes für die spätere Verwendung des Speichers und Verbinden eines redundanten Elementes entsprechend Zeile oder Spalte mit der Anordnung,

– Adressieren des so verbundenen redundanten Elementes jedesmal, wenn die Zeilenadresse oder Spaltenadresse, die am Speicher anliegt, mit der Zeilenadresse oder Spaltenadresse übereinstimmt, die von der Anordnung gespeichert ist.

2. Anordnung zur Adressierung von redundanten Elementen eines integrierten Speichers, umfassend ein Netzwerk von Speicherelementen, die in Elementenzeilen und Elementenspalten organisiert sind und durch Zeilenadressen bzw. Spaltenadressen adressierbar sind, zumindest ein redundantes Zeilenelement und ein redundantes Spaltenelement, zumindest eine Anordnung (B) von Sicherungen, die gebildet ist aus Speicherelementen (E1-E8) zur Speicherung der Adresse eines defekten Elementes des Speichers und ein Element zur Speicherung (M2) der Auswahl eines redundanten Elementes, gekennzeichnet durch

– ein Element zur Speicherung (M1) der Auswahl Zeile oder Spalte, das in Abhängigkeit von der Tatsache, ob das defekte Element ein Zeilenelement oder ein Spaltenelement ist, aktiv ist,

– eine Betätigungsschaltung (CV, S1, S2), die gesteuert ist durch das Element zur Speicherung (M1) der Auswahl Zeile oder Spalte, um einerseits zu bestimmen, ob eine in der Batterie gespeicherte Adresse eine Zeilenadresse oder eine Spaltenadresse ist und um andererseits mit der Batterie ein redundantes Element entsprechend Zeile oder Spalte zu verbinden,

– Mittel, um das so verbundene redundante Element zu adressieren und zwar jedesmal, wenn die Zeilenadresse oder Spaltenadresse, die am Speicher anliegt, mit der Zeilen adresse oder Spaltenadresse übereinstimmt, die durch die Anordnung der Sicherungen gespeichert ist.

3. Anordnung nach Anspruch 2, dadurch gekennzeichnet, daß die Bestätigungsschaltung (CV) in Übereinstimmung mit jedem Speicherelement (Ei) ein Paar logischer Glieder (N6, N0) umfaßt, von denen ein Glied (N6) an einem seiner Eingänge ein Adressen-Bit einer Zeilenadresse (A6) und an einem anderen Eingang ein Bit empfängt, das den Zustand des Elementes (M1) für die Auswahl Zeile oder Spalte überträgt, während das andere Glied (N0) an einem seiner Eingänge ein Adressen-Bit einer Spaltenadresse und an einem anderen Eingang ein Bit empfängt, das den invertierten Zustand des Elementes (M1) für die Auswahl Zeile oder Spalte überträgt;

– und daß ein logisches Glied (P1) an einem seiner Eingänge mit dem Ausgang eines Gliedes des Paares (N0, N6) und der andere Eingang mit dem Ausgang des anderen Gliedes des Paares (N0, N6) verbunden ist, während sein Ausgang mit dem Eingang zur Adressierung (Ail) eines Speicherelementes der Anordnung (B) verbunden ist.

4. Anordnung nach Anspruch 2 oder 3, dadurch gekennzeichnet, daß die Elemente zur Speicherung der Auswahl des redundanten Elementes (M2) und der Auswahl der Zeile oder der Spalte (M1) jeweils einen unterschiedlichen Durchschaltbefehl (F1), (F2) haben, der unterschiedlich ist zu demjenigen für die Sicherungen der Anordnung von Sicherungen.

# FIG_1

# FIG_2

EP 0 282 384 B1